# EUROPEAN PATENT SPECIFICATION

(11) **EP 4 409 778 B1**
(45) Date of publication and mention of the grant of the patent: **27.08.2025**
(21) Application number: 22783472.8
(22) Date of filing: 12.09.2022
(51) Int. Cl.: H04J 3/06, H04L 43/106, H04J 3/14

(54) **NETWORK CLOCK MANAGEMENT VIA DATA SERVERS**
MANAGEMENT DER NETZWERKUHR MITTELS DATENSERVER
GETSTION D'HORLOGE DE RESEAU PER SERVEURS DE DONNÉES

(30) Priority: 27.09.2021 US 202117486901
(43) Date of publication of application: 07.08.2024
(73) Proprietor: International Business Machines Corporation, Armonk, NY 10504 (US)
(72) Inventor: HOUSTON, John, POUGHKEEPSIE, New York 12601-5400 (US); GUENDERT, Stephen, Robert, POUGHKEEPSIE, New York 12601-5400 (US); CRABTREE, Donald, POUGHKEEPSIE, New York 12601-5400 (US)
(74) Representative: IBM United Kingdom Limited
(86) International application number: PCT/EP2022/075302
(87) International publication number: WO 2023/046516

(56) References cited:
- EP-A1- 3 035 569
- CN-A- 111 431 654
- US-A- 5 249 206
- US-A1- 2008 184 060
- HANADO Y ET AL: "Overview of Japan Standard Time generation", GENERAL ASSEMBLY AND SCIENTIFIC SYMPOSIUM, 2011 XXXTH URSI, IEEE, 13 August 2011 (2011-08-13), pages 1 - 4, XP032091038, ISBN: 978-1-4244-5117-3, DOI: 10.1109/URSIGASS.2011.6050281
- ESTRELA PEDRO V ET AL: "Using a multi-source NTP watchdog to increase the robustness of PTPv2 in financial industry networks", 2014 IEEE INTERNATIONAL SYMPOSIUM ON PRECISION CLOCK SYNCHRONIZATION FOR MEASUREMENT, CONTROL, AND COMMUNICATION (ISPCS), IEEE, 22 September 2014 (2014-09-22), pages 87 - 92, XP032677602, DOI: 10.1109/ISPCS.2014.6948697
- SVEN NYLUND AND ØYVIND HOLMEIDE: "IEEE 1588 Ethernet switch transparency - No need for Boundary Clocks!", INTERNET CITATION, 13 October 2004 (2004-10-13), pages 1 - 4, XP002663682, Retrieved from the Internet <URL:http://www.tekniska.pl/WebEditCMS/WebEditAll/DownloadWWW.php?IdDP=1204481820&IdFile=1213694496> [retrieved on 20111116]
- MILLS DAVID L.: "Network Time Protocol (NTP)", NETWORK WORKING GROUP D.L. MILLS REQUEST FOR COMMENTS: 958, 1 September 1985 (1985-09-01), XP055792622, Retrieved from the Internet <URL:https://www.rfc-editor.org/rfc/pdfrfc/rfc958.txt.pdf> [retrieved on 20210406]
- GEORG GADERER ET AL: "Improving Fault Tolerance in High-Precision Clock Synchronization", IEEE TRANSACTIONS ON INDUSTRIAL INFORMATICS, IEEE SERVICE CENTER, NEW YORK, NY, US, vol. 6, no. 2, 1 May 2010 (2010-05-01), pages 206 - 215, XP011334313, ISSN: 1551-3203, DOI: 10.1109/TII.2010.2044580

## Description

### BACKGROUND

Modern computing devices used to support organizations often are expected to operate in various ways to enable the organizations to satisfy various regulations and meet various standards. These standards and regulations may relate to a myriad of different computing variables, such as logging behavior or time behavior. For example, financial organizations are often required to maintain tight time synchronization of computing equipment relative to an external clock (e.g., relative to coordinated universal time (UTC)). If a financial organization uses equipment that is outside of these time synchronization requirements (such that the equipment has "drifted" to be either faster or slower than the regulations allow), the financial organization may face a significant fee. For example, a fee may be measured as a straight percentage of gross revenue of the financial organization.

As such, organizations often seek out computing devices and network infrastructure that are individually and collectively configured to satisfy such regulations and standards. Specifically, organizations may use various techniques to enable the time of day (TOD) clocks at each device to be synchronized to the extent required in today's high-end computing architectures. For example, financial organizations may use one or more time servers that read a time from a reference clock and distribute this time to various devices within a network to improve a likelihood of each of these devices utilizing the correct time (e.g., such that each device then uses the received time as their respective TOD). Time servers frequently receive this reference clock from a global positioning system (GPS) signal.

Reference is made to P. V. Estrela, S. Neusüß and W. Owczarek, "Using a multi-source NTP watchdog to increase the robustness of PTPv2 in financial industry networks," 2014 IEEE International Symposium on Precision Clock Synchronization for Measurement, Control, and Communication (ISPCS), Austin, TX, USA, 2014, pp. 87-92, doi: 10.1109/ISPCS.2014.6948697. This document describes a fundamental single point of failure in the PTPv2 protocol that affects its robustness to failure in specific error scenarios. The architecture design of electing a single unique time source to a PTP domain - the PTP GrandMaster - makes this protocol vulnerable to byzantine failures. Previous work has described this vulnerability from both a theoretical and practical point of view - and in particular how this affects the financial industry. This paper advances the discussion by contributing a description of the latest high-accuracy regulatory requirements on the financial industry, and by documenting new examples of failures in real-world customer-facing operations. It then describes an example of one of possible ways to increase PTP robustness while preserving its accuracy (using a multi-source NTP watchdog), and a laboratory test that shows how different protocol implementations are affected by this problem. In all, the current paper attempts to raise awareness of the robustness requirements within the financial industry today. As only PTP is accurate enough for both current and upcoming regulatory requirements, we hope that these issues are addressed in the forthcoming PTPv3 protocol, by adding multi-time source querying capabilities at the PTP end-slaves themselves.

EP3035569A1 describes a method to provide a cyber attack resistant and fault tolerant precision clocking scheme for wide area critical infrastructure networks through what is called Distributed Time Source Validation, DTSV, is provided, which is a distributed algorithm and signaling mechanism for a network to detect a compromised time source or sources in a multiple master clock system. The method comprises providing a local clock signal, receiving in a node R1 an external clock signal from an external source, C or S1, estimating based on the local clock signal and the external clock signal timing parameters associated with the first node and the external source, comparing the timing parameters to detect any Mutual Clock Discrepancy (MCD) between the first node and the external source, and distributing any detected MCD in the network.

### SUMMARY

The present invention is defined by the claims.

Preferably, there is provided a computer-implemented method comprising: comparing an average internal time of a plurality of data servers that each utilize a plurality of high-performance oscillators to maintain respective internal times as part of a network that utilizes precision time protocol (PTP) against other devices of the network; detecting (310), by analyzing the compared times, that a time maintained by another device of the network has drifted more than a threshold from the average internal time of all of the plurality of data servers; and executing (316, 320) an ameliorative action in response to identifying that detecting that the time maintained by the another device of the network has drifted more than the threshold. More preferably, the another device includes another data server of the plurality of data servers; and the ameliorative action includes taking a high-performance oscillator of the another data server out of service in response to identifying that the high-performance oscillator is in error.

### BRIEF DESCRIPTION OF THE DRAWINGS

The drawings included in the present application are incorporated into, and form part of, the specification. They illustrate embodiments of the present disclosure and, along with the description, serve to explain the principles of the disclosure. The drawings are only illustrative of certain embodiments and do not limit the disclosure.
FIG. 1 depicts a conceptual diagram of an example system in which a controller may manage time as stored and utilized on a plurality of computing devices of a network.
FIG. 2 depicts a conceptual box diagram of example components of the controller of FIG. 1.
FIG. 3 depicts an example flowchart by which the controller of FIG. 1 may manage time as utilized on a plurality of computing devices of a network.

While the invention is amenable to various modifications and alternative forms, specifics thereof have been shown by way of example in the drawings and will be described in detail. It should be understood, however, that the intention is not to limit the invention to the particular embodiments described. On the contrary, the intention is to cover all modifications, equivalents, and alternatives falling within the scope of the invention.

### DETAILED DESCRIPTION

Aspects of the present disclosure relate to managing clocks of computing devices of a network, while more particular aspects of the present disclosure relate to comparing an internal time of one or more data servers that use a plurality of high-performance oscillators to times of other devices of local or remote networks to identify, isolate, and execute ameliorative actions in response to identifying one or more devices of the network experiencing clock drift relative to these data servers. While the present disclosure is not necessarily limited to such applications, various aspects of the disclosure may be appreciated through a discussion of various examples using this context.

As discussed in the background, many organizations are required (or otherwise inclined) to satisfy various regulations and standards in maintaining time synchronization across their computing devices (computing devices hereinafter referred to generically as "devices). This time synchronization regulation is often in relation to a universal standard (e.g., a standard that is relative to other organizations and/or relative to a regulatory body), such that what is important is not only whether devices have clocks that are synchronized relative to each other, also synchronized relative to these external entities. To meet such regulations, organizations typically use one or more servers which are dedicated to the task of gathering a time from a (presumably reliable) reference clock and then distributing this time to other devices of the network. Such servers that are assigned (if not dedicated) to gathering and distributing a time throughout a network are referred to herein as time servers. Time servers are distinct entities from "data servers" as discussed herein, where data servers are computing devices that are configured to store data and execute computing operations on behalf of the organization (and are not charged as being a primary time distribution device). Generally speaking, data servers may be understood to be mainframes or PC data servers of the organization.

Such conventional architectures are typically reliant upon various network components (e.g., a network switch) operating as expected. For example, if a network switch of an organization network starts malfunctioning (whether by delaying a time signal sent from the time server, changing a time signal sent from the time signal, or some other error as understood by one of ordinary skill in the art), then some computing devices that rely upon that network switch to receive clock information from the time server may drift from a true time as a result of these malfunctioning components.

Some conventional architectures attempt to solve this problem by making various efforts to ensure that all devices are generally synchronized with each other, such that none drift relative to each other. For example, some conventional architectures utilize precision time protocol (PTP) throughout a network, such as in conjunction with a synchronization program that uses a Yet Another Next Generation (YANG) model to ensure that all devices are synchronized. Additionally, or alternatively, some conventional architectures may utilize server time protocol (STP), which is a server-wide facility that presents a single view of time to relevant type-1 hypervisors via STP messages transmitted over one or more physical data links between servers to improve a fidelity of messages transmitted throughout a network. Yet another example includes conventional architectures utilizing network time protocol (NTP) for clock synchronization. Using such techniques as this (whether alone or in conjunction with one or more of the procedures described above), conventional architectures may indeed be effective in ensuring that all devices are synchronized relative to each other.

However, conventional architectures may fail to identify a specific malfunctioning device that would cause single devices to drift. As would be understood by one of ordinary skill in the art, there are myriad reasons why it is beneficial to identify specific points of failure. For example, failing to identify a point of failure may make a conventional architecture susceptible to failure over time, such as if the number of malfunctioning devices multiply until a point where intra-network synchronization efforts are ineffective. For another example, failing to identify a point of failure may make it substantially more difficult for a conventional architecture to recover from an eventual failure (e.g., as it will not be known which components are required to be replaced/repaired). Specifically, following a failure, a conventional approach (where the failing devices is unknown) might include an extensive "trial and error" methodology where individual components are replaced and then the network is tested (where if that does not fix the problem, another component is replaced and the network is retested, etc.).

Beyond this, even if such conventional intra-network synchronization efforts succeed in getting all devices of a network to be synchronized relative to each other, they might not ensure that these devices are synchronized as required relative to external clocks. For example, it may be difficult or impossible for conventional synchronization efforts of conventional architectures to detect if the time server itself is malfunctioning or is receiving a corrupted time source. For example, if a malicious actor spoofs the reference clock signal used by a time server (e.g., such as the GPS signal, or even a PTP signal for some conventional architectures), conventional synchronization efforts may be technically incapable of detecting that the time received and distributed by the time server is not synchronized relative to external (e.g., true/actual) times, such as UTC.

In some situations, a network may attempt to solve this by including a single high-quality oscillator that is configured to maintain an internal time within at least one computing device of the network. However, while such a device may be configured to determine that something is wrong when its internal time did not match an external time, this device would be unable to determine if the failure is with itself or with the external device.

Aspects of this disclosure may solve or otherwise address these technical problems of conventional computing architectures. For example, the above technical problems are solved using data servers that includes multiple high-performance oscillators (e.g., where the oscillator is high-performance as a result of the oscillator being specified upon its own construction to approximately ±2 parts per million) that are configured to maintain an internal time of the data server. Such data servers may further include software that works in conjunction with the plurality of high-performance oscillators to maintain the internal time (e.g., to drift no more than 2 milliseconds a day). Aspects of the disclosure relate to comparing an internal time of day (TOD) time of one or more such data servers to internal TOD times of various devices to detect a device drifting (where drifting, as used herein, relates to a computing device getting ahead or behind a desired time by a non-nominal amount that exceeds a threshold and therein warrants correction), and therein executing an ameliorative action in response to such a detection. A computing device that includes a processing unit executing instructions stored on a memory may provide this functionality, this computing device referred to herein as a controller. By comparing various internal times of various devices with one or more data servers that utilizes multiple high-performance oscillators as described herein, the controller may be configured to detect whether any device within a computing environment device is drifting, and moreover identify whether the drift was caused by a failing device or by an error/attack relating to the incoming reference clock.

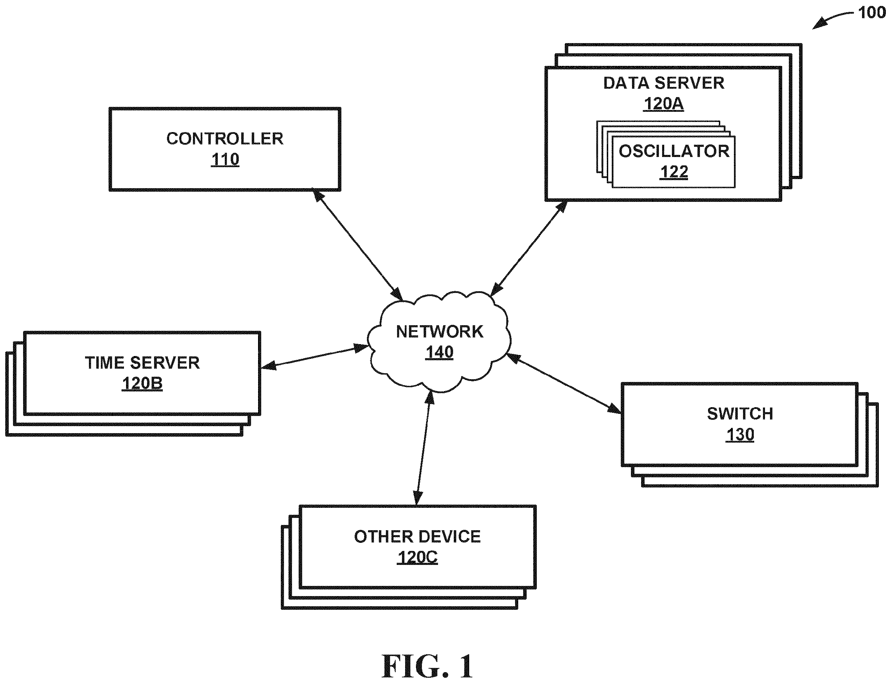

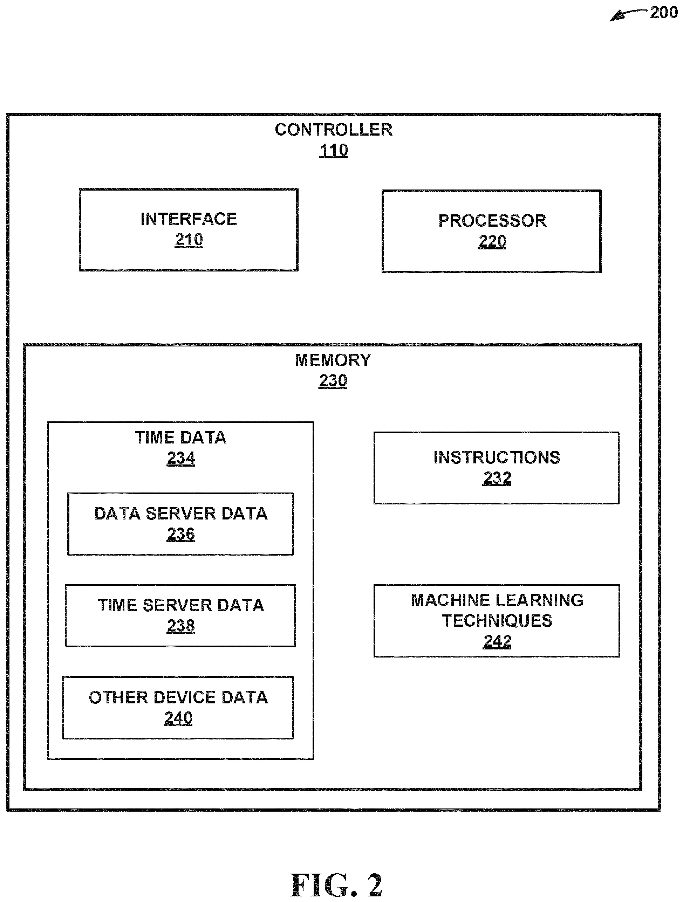

For example, FIG. 1 depicts environment 100 in which controller 110 monitors and manages internal time drift of data servers 120A, time servers 120B, and other devices 120C (where data servers 120A, time servers 120B, and other devices 120C are collectively referred to as "devices 120" herein). Controller 110 may include a computing device, such as computing system 200 of FIG. 2 that includes a processor communicatively coupled to a memory that includes instructions that, when executed by the processor, causes controller 110 to execute one or more operations described below. For example, controller 110 may monitor and manage time drift of any devices 120 on network 140. As discussed herein, all devices 120 on network 140 are to be synchronized to a true time such as the UTC (which may otherwise be phrase as the entirety of network 140 is to be synchronized to an external time).

Each data server 120A includes a plurality of high-performance oscillators 122 configured to maintain an internal time of the respective data server 120A as described herein. For example, high-performance oscillators 122 may be specified to be accurate at a range between ± 1.5 to 10 parts per million. Data servers 120A have at least two and as many as eight high-performance oscillators 122, though data servers 120A are predominantly discussed as having four high-performance oscillators 122. Each oscillator 122 may be configured to individually keep track of an internal time of data server 120A, where an eventual TOD for the respective data server 120A is an average time of each of these oscillators 122 (e.g., a mean, median, mode, of these respective times). In this way, each additional high-performance oscillator 122 may provide an additional "vote" in determining what the correct time is, such that the more oscillators 122 exist, the more robust the time synchronization efforts are (but also the more expensive each data server 120A is).

In some examples data servers 120A further utilize software to stabilize the internal time. This may include reducing drift by approximately 2 or 3 orders of magnitude better than what is enabled by high-performance oscillators 122 alone, such that a daily drift would be no more than a range of 5 milliseconds to 0.01 milliseconds per day.

As depicted, numerous time servers 120B are on network 140, but in other examples network 140 may be served by a single time server 120B. Time servers 120B are configured to receive or read a time from a reference clock, and then distribute this time to some or all devices 120 of network 140. Time servers 120B are computing devices with components that are similar to computing system 200 of FIG. 2 (e.g., such that time servers 120B includes interface 210, processor 220, and memory 230 as discussed in relation to FIG. 2 in some capacity). Time servers 120 may be understood to not necessarily include high performance oscillators 122.

Comparatively, data servers 120A are not used within network 140 for a default task of receiving and distributing a reference clock signal throughout network 140 (e.g., such that upon initializing network 140, data servers 120A are not assigned an initial task of gathering a time from a reference clock and distributing a clock signal to device 120 of network 140). Rather, data servers 120A may be understood to be mainframe computing devices or PC data servers. As such, data servers 120A may be understood to be used for primary computing operations for an organization that is utilizing network 140 (e.g., such that data servers 120A are part of the central data repository for the organization).

Other devices 120C include computing devices of network 140 that are to be synchronized along with data servers 120A within network 140 but are not time servers 120B and are more capable of drifting than data servers 120A. For example, other devices 120C may include servers that do not have any high-performance oscillators 122, or perhaps have a single high-performance oscillator 122, or are otherwise not configured to be as drift-resistant as data servers 120A. In some examples, other devices 120C are mainframe computing devices or PC data servers. Both data servers 120A and other devices 120C are computing devices with components that are similar to computing system 200 of FIG. 2 (e.g., such that both include interface 210, processor 220, and memory 230 in some capacity as discussed in relation to FIG. 2)

In some examples, controller 110 is separate from devices 120 as depicted in FIG. 1, such that controller 110 manages time synchronization of network 140 as part of a computing device that is physically discrete relative to devices 120. In other examples (not depicted), controller 110 may be integrated into one or many of devices 120 (e.g., perhaps as a distributed system). For example, controller 110 may be integrated into one data server 120A, and/or controller 110 may be integrated as individual instances into each or many of data servers 120A.

As discussed herein, time servers 120B send a reference clock signal to data servers 120A and other devices 120C. Time servers 120B use a plurality of switches 130 to send the reference clock signal through network 140 to data servers 120A and other devices 120C. Switches 130 are network switches that connect devices 120 via techniques such as packet switching on one or more layers of the open systems interconnection (OSI) model.

Network 140 may include one or more computer communication networks. An example network 140 can include the Internet, a local area network (LAN), a wide area network (WAN), a wireless network such as a wireless LAN (WLAN), or the like. Network 140 may comprise copper transmission cables, optical transmission fibers, wireless transmission, routers, firewalls, switches, gateway computers and/or edge servers. That said, connections of network 140 that are between time servers 120B and devices 120 may only utilize such connections as are capable of the high-speed data transmission required for data synchronization as described herein. For example, each of devices 120 and switches 130 may be connected to respective time servers 120B that serve these devices 120 over a LAN. A network adapter card or network interface in each computing/processing device (e.g., controller 110, data server 120A, time server 120B, other devices 120C) may receive messages and/or instructions from and/or through network 140 and forward the messages and/or instructions for storage or execution or the like to a respective memory or processor of the respective computing/processing device.

Though network 140 is depicted as a single entity in FIG. 1 for purposes of illustration, in other examples network 140 may include a plurality of private and/or public networks over which controller 110 may manage time as described herein. For example, in some situations network 140 may include two clustered subnetworks in which devices 120 are connected via respective LANs, and additionally connected via a WAN or the like even as these two clustered subnetworks are geographically dispersed. Specifically, the two clustered subnetwork may be located, e.g., in different buildings, different cities, or otherwise on the realm of 100,000 kilometers away. In this example, each of the two geographically dispersed clustered subnetworks includes at least one time server 120B and at least one data server 120A, and controller 110 (whether one controller 110 or distinct instances of controller 110) manages time synchronization and time drift of devices 120 in the two geographically dispersed clustered subnetworks.

Controller 110 detects that a time maintained by at least one device 120 of network 140 is more than a threshold away from a time maintained by at least one data server 120A. For example, a threshold may be 50 microsecond, 100 microseconds, or 200 microseconds, and controller 110 may detect that a time of a TOD clock of one of devices 120 is 51 microseconds, 111 microseconds, or 201 microseconds (respectively) away from a time maintained by a single data server 120A, and therefore exceeds the respective threshold. While these specific threshold numbers are provided for purposes of discussion, one of ordinary skill in the art would understand that such numbers are heavily dependent upon the regulations related to the organization of network 140 and the specifications/capabilities of devices 120 of network 140 (e.g., such that devices 120 that are capable of tighter tolerances might have smaller thresholds, and/or organizations that are held to "lower" regulations might have notably larger thresholds). Therefore, one of ordinary skill in the art would understand that any user-defined threshold that identifies a drift that is both larger than a time synchronization that is capable of being maintained by devices 120 and also approaching (or potentially failing) the allowable limit of drift as defined by various regulations and/or standards applicable to the organization is consistent with this disclosure.

Controller 110 executes an ameliorative action in response to detecting this drift by more than the threshold. An ameliorative action may include invoking the best master clock algorithm, invoking STP links, changing a clock signal from being propagated throughout network 140 by time server 120B being propagated throughout network 140 by one or more data servers 120A to devices 120, notifying an admin of the time drift (e.g., including identifying which device 120 has drifted by what amount), taking one or more malfunctioning oscillators 122 out of service, or the like.

In some examples, controller 110 may compare a time of devices 120 against a single data server 120A. For example, a local network 140 could include one single data server 120A, and controller 110 may execute an ameliorative action as discussed herein in response to detecting that any of devices 120 were more than a threshold amount of time away from an internal time of this single data server 120A. For example, controller 110 could detect that time server 120B is malfunctioning (or has received a bad reference signal) as a result of detecting that the time of time server 120B is different than one single data server 120A.

In other examples, a single network 140 on one LAN (e.g., within a single room, or a single building) may include numerous data servers 120A, and controller 110 may compare a time of individual devices 120 against the average time of multiple data servers 120A. Controller 110 may calculate an average time of multiple data servers 120A via any number of statistical methods, such as by calculating a mean, median, mode, or some other statistical method. For example, controller 110 may compare a time of one time server 120B of a LAN of network 140 against some or all data servers 120A of that network 140 LAN.

Controller 110 may compare an internal time of devices 120 to the time of data servers 120A on a set schedule, and/or in response to a condition being met. For example, controller 110 may compare an internal time of each of devices 120 against the average time of data servers 120A once every 30 minutes, once every hour, once every 12 hours, once every day, once every few days, or the like. Controller 110 may compare a time of devices 120 against the time of data servers 120A more frequently to catch a potential drift sooner, whereas controller 110 may compare less frequently to use less computing resources. In some examples, controller 110 may be configured to compare times of devices 120 against times of data servers 120A in response to a resource utilization falling below a threshold (e.g., in response to a processing, memory, and or bandwidth utilization rate of network 140 falling below some percentage, indicating that there is surplus computing resources for use). Additionally, or alternatively, controller 110 may be configured to compare a time of devices 120 to a time of data servers 120A in response to something being detected that indicates drifting (e.g., an error, alert, or condition that is correlated to one or more devices 120 drifting).

Controller 110 may execute ameliorative actions autonomously. Specifically, controller 110 may execute ameliorative actions as discussed herein without intervention from a human. Beyond this, controller 110 may execute ameliorative actions nearly immediately upon detecting that a time of one or more of devices 120 is drifting, such as within a millisecond or a second of such detection. By being configured to autonomously and nearly immediately execute an ameliorative action in response to detecting any devices 120 drifting, aspects of this controller 110 may improve the likelihood of devices 120 utilizing the correct time (and therein reduce the likelihood that an organization that is using these devices 120 will have to pay a fine or the like as a result of any devices 120 not utilizing the correct time for an extended period of time).

As discussed herein, in some examples controller 110 detects that a time as maintained and/or received by time server 120B of network 140 is more than a threshold away from the average time of a plurality of data servers 120. In response to such a detection, controller 110 executes an ameliorative action. For example, controller 110 may notify an admin and also cause devices 120 of environment 100 to receive a clock signal that is the average time of the plurality of data servers 120 (rather than the clock signal from the time server 120B that is drifting). In this way, in response to detecting that a time of time server 120B is drifting relative to the average time of a plurality of data servers 120A, controller causes devices 120 to utilize the average internal time of the plurality of data servers 120A.

In certain examples, controller 110 may compare devices 120 of one geographic location against data servers 120A of a different geographic location. For example, controller 110 may compare data servers 120A of one geographic location against data servers 120A of a second geographic location. Alternatively, or additionally, controller 110 may compare how devices 120 of a first location are drifting relative to data servers 120A of that first location, and then compare that drift against how devices 120 of a second location are drifting relative to data servers of that second location. In this way, aspects of this disclosure may be configured to enable tight time synchronization for widely dispersed networks, such as a graphically dispersed parallel sysplex (GDPS).

In other examples, controller 110 may compare a time of a first time server 120B at one location against both a time server 120B and data servers 120A of a second location. Specifically, controller 110 may detect that time server 120B at a first location has an incorrect time, and may compare this incorrect time against a time of a time server 120B at a second location that is geographically dispersed from the first location. Where controller 110 detects that these two time servers 120B both have incorrect times that are within a threshold of each other (e.g., within 100 or 1000 microseconds of each other), controller 110 may conclude that the problem is likely with a time source rather than the time servers 120B themselves. In this way, aspects of the disclosure may be configured to determine that, e.g., a malicious third party appears to be tampering with a time source, such as a GPS signal (e.g., via GPS spoofing). In response to such a determination, controller 110 may cause devices 120 of both locations to instead use times of data servers 120A rather than time servers 120B, at least until an admin can verify conditions of the two locations.

Controller 110 is configured to detect if one data server 120A is drifting relative to other data servers 120A. Where controller 110 detects that one data server 120A is drifting relative to other data servers 120A, controller 110 may analyze a performance of each oscillator 122 of this drifting data server 120A. In many cases, controller 110 will identify at least one oscillator 122 of the drifting data server 120A that is in error and is therein causing this data server 120A to drift. In response to detecting one or more oscillators 122 that are in error, controller 110 may execute an autonomous action of taking these erring oscillators 122 out of service within the drifting data server 120A. Controller 110 may further notify an admin and/or request a replacement oscillator 122 for the (previously) drifting data server 120A.

Additionally, or alternatively, controller 110 may take data server 120A out of service in response to detecting that data server 120A was drifting (in response to erring oscillator 122). In other examples, controller 110 may treat this previously drifting data server 120A as a new other device 120C rather than a data server 120A in response to detecting that this previously drifting data server 120 was drifting (and/or in response to taking one oscillator 122 out of service). Put differently, controller 110 may not compare other devices 120 against this previously drifting data server 120A until this previously drifting data server 120A is fully serviced and repaired, such that this previously drifting data server 120A is confirmed to have a performance along the lines of other data servers 120A (e.g., four working oscillators 122 that each are specified to ±2 ppm).

Controller 110 may be configured to detect when one other device 120C is drifting. In response to controller 110 detecting that one other devices 120C is drifting, controller 110 may check whether or not any more other devices 120C are drifting. If more other devices 120C are drifting, controller 110 may compare the drift between these other devices 120C to see if they are similar. Where controller 110 determines that more than one other devices 120C are drifting a similar amount, controller 110 may identify commonalities of a route through which these other devices 120C received a clock signal from time server 120B. For example, controller 110 may determine that within network 140 that includes forty other devices 120C, that eight other devices 120C are experiencing substantially identical drifts, and moreover that all of these eight other devices 120C share a common switch 130. In response to this determination that a common switch 130 is involved in all drifting other devices 120C, controller 110 may execute an ameliorative action of rerouting the clock signal to the previously drifting other devices 120C (e.g., through a new route that avoids the problematic switch 130). Controller 110 may also notify an admin of the seemingly malfunctioning switch 130.

In other examples, upon analyzing all other devices 120C (in response to detecting that one other device 120C is drifting), controller 110 may determine that no additional other devices 120C is drifting (or drifting in a similar manner) beyond this one other device 120C. In response to such a determination, controller 110 may execute an ameliorative action that includes one or more of reporting this problem to an admin, invoking the best master clock algorithm, switching the drifting other device 120C to receive the time from a neighboring device 120, or the like.

As described above, controller 110 may be part of a computing device that includes a processor configured to execute instructions stored on a memory to execute the techniques described herein. For example,

FIG. 2 is a conceptual box diagram of such computing system 200 of controller 110. While controller 110 is depicted as a single entity (e.g., within a single housing) for the purposes of illustration, in other examples, controller 110 may include two or more discrete physical systems (e.g., within two or more discrete housings). Controller 110 may include interfaces 210, processor 220, and memory 230. Controller 110 may include any number or amount of interface(s) 210, processor(s) 220, and/or memory(s) 230.

Controller 110 may include components that enable controller 110 to communicate with (e.g., send data to and receive and utilize data transmitted by) devices that are external to controller 110. For example, controller 110 may include interface 210 that is configured to enable controller 110 and components within controller 110 (e.g., such as processor 220) to communicate with entities external to controller 110. Specifically, interface 210 may be configured to enable components of controller 110 to interact with devices 120, switches 130, or the like. Interface 210 may include one or more network interface cards, such as Ethernet cards and/or any other types of interface devices that can send and receive information. Various numbers of interfaces may be used to perform the described functions according to particular needs.

As discussed herein, controller 110 may be configured to manage time synchronization within a computing network. Controller 110 may utilize processor 220 to thusly manage time. Processor 220 may include, for example, microprocessors, digital signal processors (DSPs), application specific integrated circuits (ASICs), field-programmable gate arrays (FPGAs), and/or equivalent discrete or integrated logic circuits. Two or more of processor 220 may be configured to work together to identify whether or not any devices 120 are drifting and execute ameliorative actions accordingly.

Processor 220 may manage time of devices 120 in environment 100 according to instructions 232 stored on memory 230 of controller 110. Memory 230 may include a computer-readable storage medium or computer-readable storage device. In some examples, memory 230 includes one or more of a short-term memory or a long-term memory. Memory 230 may include, for example, random access memories (RAM), dynamic random-access memories (DRAM), static random-access memories (SRAM), magnetic hard discs, optical discs, floppy discs, flash memories, forms of electrically programmable memories (EPROM), electrically erasable and programmable memories (EEPROM), or the like.

In addition to instructions 232, in some examples gathered or predetermined data or techniques or the like as used by processor 220 to manage time drift and synchronization as described herein is stored within memory 230. For example, memory may also include time data 234, which may include various thresholds and schedules at which controller 110 is to monitor internal time of devices 120. Memory 230 may also include data server data 236, time server data 238, and other device data 240. Data server data 236 may include historical and/or current time data for data servers 120A, while time server data 238 may include historical and/or current time data for time servers 120B, and other device data 240 includes historical and/or current time data for other devices 120C.

Memory 230 may further include machine learning techniques 242 that controller 110 may use to improve a process of managing time synchronization and drifting as discussed herein over time. Machine learning techniques 242 can comprise algorithms or models that are generated by performing supervised, unsupervised, or semi-supervised training on a dataset, and subsequently applying the generated algorithm or model to monitor time synchronization or drift as described herein. For example, using machine learning techniques 242, controller 110 may determine that certain drift thresholds for certain types of devices 120 are more indicative of drift, and/or are more likely to result in a problematic drift before a next schedule scan. For another example, controller 110 may use machine learning techniques 242 to determine that certain types of ameliorative actions are better or worse at reducing drift over time. Controller 110 may reinforce rules over time based on whether an ability to reduce time drift improves or declines based on rule updates. For example, controller 110 may track whether or not any an amount of drifts that required ameliorative actions are increasing or decreasing and either change or stabilize future actions accordingly.

Machine learning techniques 242 can include, but are not limited to, decision tree learning, association rule learning, artificial neural networks, deep learning, inductive logic programming, support vector machines, clustering, Bayesian networks, reinforcement learning, representation learning, similarity/metric training, sparse dictionary learning, genetic algorithms, rule-based learning, and/or other machine learning techniques.

For example, machine learning techniques 242 can utilize one or more of the following example techniques: K-nearest neighbor (KNN), learning vector quantization (LVQ), self-organizing map (SOM), logistic regression, ordinary least squares regression (OLSR), linear regression, stepwise regression, multivariate adaptive regression spline (MARS), ridge regression, least absolute shrinkage and selection operator (LASSO), elastic net, least-angle regression (LARS), probabilistic classifier, naïve Bayes classifier, binary classifier, linear classifier, hierarchical classifier, canonical correlation analysis (CCA), factor analysis, independent component analysis (ICA), linear discriminant analysis (LDA), multidimensional scaling (MDS), non-negative metric factorization (NMF), partial least squares regression (PLSR), principal component analysis (PCA), principal component regression (PCR), Sammon mapping, *t*-distributed stochastic neighbor embedding (t-SNE), bootstrap aggregating, ensemble averaging, gradient boosted decision tree (GBRT), gradient boosting machine (GBM), inductive bias algorithms, Q-learning, state-action-reward-state-action (SARSA), temporal difference (TD) learning, apriori algorithms, equivalence class transformation (ECLAT) algorithms, Gaussian process regression, gene expression programming, group method of data handling (GMDH), inductive logic programming, instance-based learning, logistic model trees, information fuzzy networks (IFN), hidden Markov models, Gaussian naïve Bayes, multinomial naïve Bayes, averaged one-dependence estimators (AODE), Bayesian network (BN), classification and regression tree (CART), chi-squared automatic interaction detection (CHAID), expectation-maximization algorithm, feedforward neural networks, logic learning machine, self-organizing map, single-linkage clustering, fuzzy clustering, hierarchical clustering, Boltzmann machines, convolutional neural networks, recurrent neural networks, hierarchical temporal memory (HTM), and/or other machine learning algorithms.

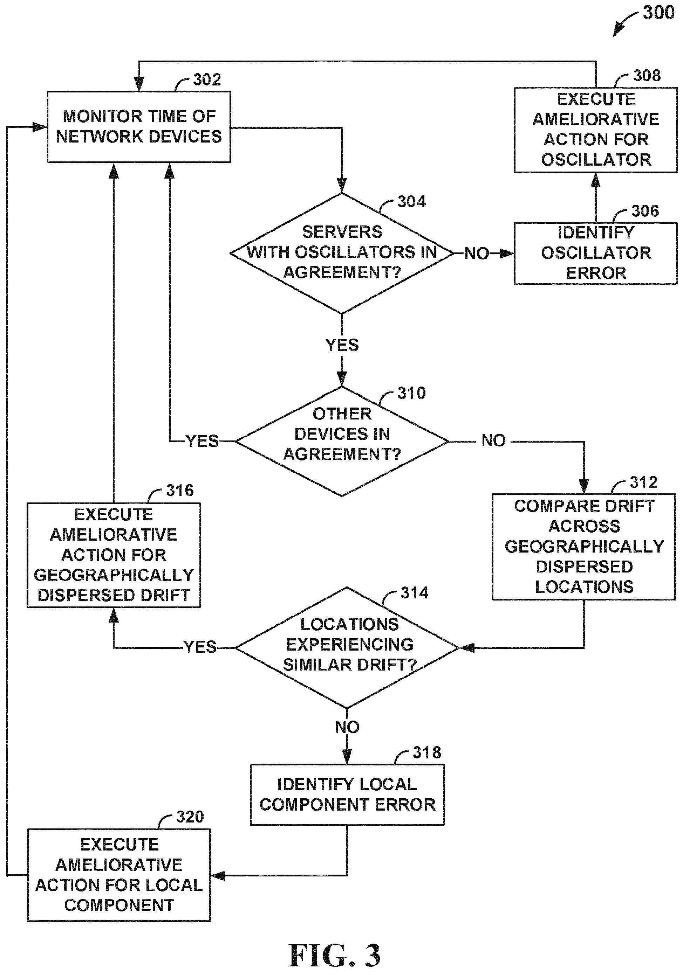

Using these components, controller 110 may manage time synchronization and drift as discussed herein. In some examples, controller 110 manages time synchronization of devices 120 according to flowchart 300 depicted in FIG. 3. Flowchart 300 of FIG. 3 is discussed with relation to FIG. 1 for purposes of illustration, though it is to be understood that other systems and message may be used to execute flowchart 300 of FIG. 3 in other examples. Further, in some examples controller 110 executes a different method than flowchart 300 of FIG. 3, or controller 110 executes a similar method with more or less steps in a different order, or the like.

Flowchart 300 starts with controller 110 monitoring an internal time (e.g., a TOD) of devices 120 of network 140 (302). Controller 110 may determine whether or not data servers 120A are in agreement with each other, such that all data servers 120A are within a tight tolerance/threshold of each other (304). If controller 110 determines that any data servers 120A are outside of a threshold (no branch from 304), controller 110 may attempt to identify whether any oscillators 122 are in error (306). Controller 110 may then execute an ameliorative action (308), whether taking an erring oscillator 122 out of service, taking the erring data server 120A out of service, requesting a replacement oscillator 122, notifying an admin, treating the erring data server 120A as an other device 120C, or the like.

If controller 110 determines that all data servers 120A are in agreement (yes branch from 304), controller 110 determines whether or not other devices 120C are in agreement within a threshold (310). If other devices 120C are in agreement (yes branch from 310), controller 110 continues monitoring time of devices 120 (e.g., at a next scheduled time). If other devices 120C are not in agreement (no branch from 310), controller 110 may compare the drift experienced locally against a drift experienced by geographically dispersed devices 120 (e.g., other devices 120 of a shared WAN) (312).

Controller 110 may verify whether or not geographically dispersed devices 120 are experiencing a similar drift (314). For example, controller 110 may determine that all other devices 120C of a first geographic location served by a first time server 120B are experiencing a drift of a first magnitude, and all other devices 120C of a second geographic location serviced by a second time server 120B are experiencing a drift of a second magnitude, where the first drift and the second drift are substantially similar (yes branch from 314).

One of ordinary skill in the art would understand that a drift would be understood to be substantially similar if the two drifts are so close such that it is unlikely to be a coincidence, and that rather it is more likely that the two drifts are the result of both receiving the same (potentially malicious) incorrect reference clock. The exact value that would merit such a determination might change depend upon the situation, such as the accuracy of the components and/or the precision of a potential attack, though an example threshold to be identified as substantially similar might be within 0.01 seconds of each other. In response to this determination, controller 110 may execute an ameliorative action for geographically dispersed drift (316). This may include notifying an admin that a time source appears to have been spoofed, changing a time source for a given network 140 to be a(n average) time of data servers 120A rather than the gathered reference time of time servers 120B, or the like. After executing this ameliorative action, controller 110 may return to monitoring devices 120 (302).

If controller 110 determines that a geographically dispersed location is not experiencing a similar drift (no branch from 314), controller 110 may track the clock signal to identify a local component error (318). A component may include switches 130, other devices 120C, and/or time servers 120B. For example, if numerous other devices 120C are all drifting and all share a respective switch 130, controller 110 may identify that the respective switch 130 is in error and may execute an ameliorative action (320) of routing the clock signal to these other devices 120C without going through this respective switch 130. If controller 110 determines that numerous other devices 120C that are serviced by a single time server 120B are drifting, then controller 110 may execute an ameliorative action (320) of causing these other devices 120C to instead receive a clock signal from data servers 120A as discussed herein (or cause these other devices 120C to be serviced by another time server 120B of network 140, as applicable). Alternatively, if controller 110 determines that a single other device 120C was drifting, then controller 110 may execute an ameliorative action (320) of executing STP and/or causing this single other device 120C to receive time from a nearby device 120.

The descriptions of the various embodiments of the present disclosure have been presented for purposes of illustration, but are not intended to be exhaustive or limited to the embodiments disclosed. Many modifications and variations will be apparent to those of ordinary skill in the art without departing from the scope of the described embodiments. The terminology used herein was chosen to explain the principles of the embodiments, the practical application or technical improvement over technologies found in the marketplace, or to enable others of ordinary skill in the art to understand the embodiments disclosed herein.

The present invention may be a system, a method, and/or a computer program product at any possible technical detail level of integration. The computer program product may include a computer readable storage medium (or media) having computer readable program instructions thereon for causing a processor to carry out aspects of the present invention.

The computer readable storage medium can be a tangible device that can retain and store instructions for use by an instruction execution device. The computer readable storage medium may be, for example, but is not limited to, an electronic storage device, a magnetic storage device, an optical storage device, an electromagnetic storage device, a semiconductor storage device, or any suitable combination of the foregoing. A non-exhaustive list of more specific examples of the computer readable storage medium includes the following: a portable computer diskette, a hard disk, a random access memory (RAM), a read-only memory (ROM), an erasable programmable read-only memory (EPROM or Flash memory), a static random access memory (SRAM), a portable compact disc read-only memory (CD-ROM), a digital versatile disk (DVD), a memory stick, a floppy disk, a mechanically encoded device such as punch-cards or raised structures in a groove having instructions recorded thereon, and any suitable combination of the foregoing. A computer readable storage medium, as used herein, is not to be construed as being transitory signals per se, such as radio waves or other freely propagating electromagnetic waves, electromagnetic waves propagating through a waveguide or other transmission media (e.g., light pulses passing through a fiber-optic cable), or electrical signals transmitted through a wire.

Computer readable program instructions described herein can be downloaded to respective computing/processing devices from a computer readable storage medium or to an external computer or external storage device via a network, for example, the Internet, a local area network, a wide area network and/or a wireless network. The network may comprise copper transmission cables, optical transmission fibers, wireless transmission, routers, firewalls, switches, gateway computers and/or edge servers. A network adapter card or network interface in each computing/processing device receives computer readable program instructions from the network and forwards the computer readable program instructions for storage in a computer readable storage medium within the respective computing/processing device.

Computer readable program instructions for carrying out operations of the present invention may be assembler instructions, instruction-set-architecture (ISA) instructions, machine instructions, machine dependent instructions, microcode, firmware instructions, state-situation data, configuration data for integrated circuitry, or either source code or object code written in any combination of one or more programming languages, including an object oriented programming language such as Smalltalk, C++, or the like, and procedural programming languages, such as the "C" programming language or similar programming languages. The computer readable program instructions may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider). In some embodiments, electronic circuitry including, for example, programmable logic circuitry, field-programmable gate arrays (FPGA), or programmable logic arrays (PLA) may execute the computer readable program instructions by utilizing state information of the computer readable program instructions to personalize the electronic circuitry, in order to perform aspects of the present invention.

Aspects of the present invention are described herein with reference to flowchart illustrations and/or block diagrams of methods, apparatus (systems), and computer program products according to embodiments of the invention. It will be understood that each block of the flowchart illustrations and/or block diagrams, and combinations of blocks in the flowchart illustrations and/or block diagrams, can be implemented by computer readable program instructions.

These computer readable program instructions may be provided to a processor of a general purpose computer, special purpose computer, or other programmable data processing apparatus to produce a machine, such that the instructions, which execute via the processor of the computer or other programmable data processing apparatus, create means for implementing the functions/acts specified in the flowchart and/or block diagram block or blocks. These computer readable program instructions may also be stored in a computer readable storage medium that can direct a computer, a programmable data processing apparatus, and/or other devices to function in a particular manner, such that the computer readable storage medium having instructions stored therein comprises an article of manufacture including instructions which implement aspects of the function/act specified in the flowchart and/or block diagram block or blocks.

The computer readable program instructions may also be loaded onto a computer, other programmable data processing apparatus, or other device to cause a series of operational steps to be performed on the computer, other programmable apparatus or other device to produce a computer implemented process, such that the instructions which execute on the computer, other programmable apparatus, or other device implement the functions/acts specified in the flowchart and/or block diagram block or blocks.

The flowchart and block diagrams in the Figures illustrate the architecture, functionality, and operation of possible implementations of systems, methods, and computer program products according to various embodiments of the present invention. In this regard, each block in the flowchart or block diagrams may represent a module, segment, or portion of instructions, which comprises one or more executable instructions for implementing the specified logical function(s). In some alternative implementations, the functions noted in the blocks may occur out of the order noted in the Figures. For example, two blocks shown in succession may, in fact, be accomplished as one step, executed concurrently, substantially concurrently, in a partially or wholly temporally overlapping manner, or the blocks may sometimes be executed in the reverse order, depending upon the functionality involved. It will also be noted that each block of the block diagrams and/or flowchart illustration, and combinations of blocks in the block diagrams and/or flowchart illustration, can be implemented by special purpose hardware-based systems that perform the specified functions or acts or carry out combinations of special purpose hardware and computer instructions.

## Claims

1. A computer-implemented method comprising:
comparing an internal time of a data server on a network against respective times of each of plurality of devices on the network, wherein the data server comprises a plurality of high-performance oscillators to maintain the internal time of the data server on the network, wherein each high-performance oscillator in the plurality of high-performance oscillators keeps track of the internal time of the data server individually, and wherein the internal time of the data server is an average time obtained from the plurality of high-performance oscillators;
detecting (310), by analyzing the compared times, that a time maintained by another device of the network has drifted more than a threshold; and
executing (316, 320) an ameliorative action in response to detecting that the time maintained by the another device has drifted more than the threshold.

2. The computer-implemented method of claim 1, wherein the another device is a time server of the network.

3. The computer-implemented method of claim 2, wherein:
the data server is one of a plurality of data servers that each utilize a plurality of high-performance oscillators to maintain respective internal times;
the detecting that the time of the time server has drifted more than the threshold includes comparing the time of the time server against an average internal time of all of the plurality of data servers; and
the ameliorative action includes causing the network to utilize the average internal time of all of the plurality of data servers rather than the time of the time server in response to detecting that the time of the time server has drifted more than the threshold from the average internal time.

4. The computer-implemented method of claim 3, wherein the ameliorative action is executed autonomously.

5. The computer-implemented method of claim 1, wherein:
the data server is one of a plurality of data servers that each utilize a plurality of high-performance oscillators to maintain respective internal times; and
the detecting that the time of the another device has drifted more than the threshold includes comparing the time of the another device against an average internal time of all of the plurality of data servers, the method further comprising:
identifying that a switch of the network is a cause of the another device drifting more than the threshold by tracking an erring clock signal to the switch.

6. The computer-implemented method of claim 5, wherein the ameliorative action includes:
sending a notification to an administrator: and
invoking the best master clock algorithm.

7. The computer-implemented method of claim 1, wherein the network utilizes precision time protocol to synchronize internal times of the plurality of internal devices.

8. The computer-implemented method of claim 7, wherein the ameliorative action includes invoking the best master clock algorithm.

9. The computer-implemented method of claim 1, wherein:
the another device is another data server of the network; and
the ameliorative action includes autonomously taking the data server out of service.

10. The computer-implemented method of claim 1, wherein:
the network is geographically dispersed and includes two clustered subnetworks;
the data server is one of a plurality of data servers at a first of the two clustered subnetwork where each data server of the first plurality of data servers utilizes a respective plurality of high-performance oscillators to maintain respective internal times;
the another device is a time server of the first clustered subnetwork;
the detecting that the time of the time server of the first clustered subnetwork has drifted more than the threshold includes comparing the time of the time server of the first clustered subnetwork against an average internal time of all of the plurality of data servers, the method further comprising:
comparing an internal time of a time server of a second of the two clustered subnetworks against the average internal time of all of the plurality of data servers;
detecting that the time server of the second clustered subnetwork has drifted in a manner substantially similar to the manner than the time server of the first clustered subnetwork has drifted; and
detecting that a clock source of the time servers at both the first and second clustered subnetworks has been compromised as a result of detecting that the time servers are drifting in a substantially similar manner.

11. The computer-implemented method of claim 1, wherein:
the data server is one of a plurality of data servers that each utilize a plurality of high-performance oscillators to maintain respective internal times;
the detecting that the time of the another device has drifted more than the threshold includes comparing the time of the another device against an average internal time of all of the plurality of data servers;
the another device includes another data server of the plurality of data servers; and
the ameliorative action includes taking a high-performance oscillator of the another data server out of service in response to identifying that the high-performance oscillator is in error.

12. The computer-implemented method of claim 1, wherein:
the plurality of high-performance oscillators includes at least four oscillators that are each specified to be accurate to at least ± 2 parts per million; and
the data server is configured to use software in conjunction with the plurality of high-performance oscillators to maintain the internal time to drift no more than two milliseconds a day

13. A data server (120A) on a network of a plurality of devices, the data server comprising:
a plurality of high-performance oscillators (122);
a processor; and
a memory in communication with the processor, the memory containing instructions (232) that, when executed by the processor, cause the processor to:
compare an internal time of the data server against respective times of each of the plurality of devices on the network, wherein the data server utilizes the plurality of high-performance oscillators to maintain the internal time of the data server on the network, wherein each high-performance oscillator in the plurality of high-performance oscillators keeps track of the internal time of the data server individually, and wherein the internal time of the data server is an average time obtained from the plurality of high-performance oscillators;
detect, by analyzing the compared times, that a time maintained by another device of the network has drifted more than a threshold; and
execute an ameliorative action in response to detecting that the time maintained by the another device has drifted more than the threshold.

14. A computer program stored on a computer readable medium and loadable into the internal memory of a digital computer, the computer program comprising software code portions for performing the method of any of claims 1 to 12 when said program is run on a computer.

## Patentansprüche

1. Computerrealisiertes Verfahren, das aufweist:
Vergleichen einer internen Zeit eines Datenservers in einem Netzwerk mit den jeweiligen Zeiten von jeder einer Mehrzahl von Einheiten in dem Netzwerk, wobei der Datenserver eine Mehrzahl von Hochleistungsoszillatoren aufweist, um die interne Zeit des Datenservers in dem Netzwerk zu verwalten, wobei jeder Hochleistungsoszillator in der Mehrzahl von Hochleistungsoszillatoren die interne Zeit des Datenservers einzeln verfolgt, und wobei es sich bei der internen Zeit des Datenservers um eine mittlere Zeit handelt, die von der Mehrzahl von Hochleistungsoszillatoren erhalten wird;
Erkennen (310), durch Analysieren der verglichenen Zeiten, dass eine von einer weiteren Einheit des Netzwerks verwaltete Zeit über einen Schwellenwert hinaus abgewichen ist; und
Durchführen (316, 320) einer Abhilfemaßnahme in Reaktion auf das Erkennen, dass die von der weiteren Einheit verwaltete Zeit über den Schwellenwert hinaus abgewichen ist.

2. Computerrealisiertes Verfahren nach Anspruch 1, wobei es sich bei der weiteren Einheit um einen Zeitserver des Netzwerks handelt.

3. Computerrealisiertes Verfahren nach Anspruch 2, wobei:
es sich bei dem Datenserver um einen aus einer Mehrzahl von Datenservern handelt, die jeweils eine Mehrzahl von Hochleistungsoszillatoren zum Verwalten der jeweiligen internen Zeiten verwenden;
das Erkennen, dass die Zeit des Zeitservers über den Schwellenwert hinaus abgewichen ist, das Vergleichen der Zeit des Zeitservers mit einer mittleren internen Zeit aller Datenserver aus der Mehrzahl von Datenservern enthält; und
die Abhilfemaßnahme das Veranlassen des Netzwerks enthält, die mittlere interne Zeit aller Datenserver aus der Mehrzahl von Datenservern anstelle der Zeit des Zeitservers in Reaktion auf das Erkennen zu verwenden, dass die Zeit des Zeitservers von der mittleren internen Zeit über den Schwellenwert hinaus abgewichen ist.

4. Computerrealisiertes Verfahren nach Anspruch 3, wobei die Abhilfemaßnahme autonom durchgeführt wird.

5. Computerrealisiertes Verfahren nach Anspruch 1, wobei:
es sich bei dem Datenserver um einen aus einer Mehrzahl von Datenservern handelt, die jeweils eine Mehrzahl von Hochleistungsoszillatoren zum Verwalten der jeweiligen internen Zeiten verwenden; und
das Erkennen, dass die Zeit der weiteren Einheit über den Schwellenwert hinaus abgewichen ist, das Vergleichen der Zeit der weiteren Einheit mit einer mittleren internen Zeit aller Datenserver aus der Mehrzahl von Datenservern enthält, wobei das Verfahren ferner aufweist:
Identifizieren, dass ein Switch des Netzwerks eine Ursache dafür ist, dass die weitere Einheit über den Schwellenwert hinaus abgewichen ist, indem ein fehlerhaftes Taktsignal zu dem Switch zurück verfolgt wird.

6. Computerrealisiertes Verfahren nach Anspruch 5, wobei die Abhilfemaßnahme enthält:
Senden einer Benachrichtigung an einen Administrator; und
Aufrufen des Best-Master-Clock-Algorithmus.

7. Computerrealisiertes Verfahren nach Anspruch 1, wobei das Netzwerk das Precision-Time-Protokoll zum Synchronisieren der internen Zeiten der Mehrzahl von internen Einheiten verwendet.

8. Computerrealisiertes Verfahren nach Anspruch 7, wobei die Abhilfemaßnahme das Aufrufen des Best-Master-Clock-Algorithmus enthält.

9. Computerrealisiertes Verfahren nach Anspruch 1, wobei:
es sich bei der weiteren Einheit um einen weiteren Datenserver des Netzwerks handelt; und
die Abhilfemaßnahme die autonome Außerbetriebnahme des Datenservers enthält.

10. Computerrealisiertes Verfahren nach Anspruch 1, wobei:
das Netzwerk geographisch verteilt ist und zwei geclusterte Teilnetzwerke enthält;
es sich bei dem Datenserver um einen aus einer Mehrzahl von Datenservern an einem ersten der zwei geclusterten Teilnetzwerke handelt, wobei jeder Datenserver aus der ersten Mehrzahl von Datenservern eine jeweilige Mehrzahl von Hochleistungsoszillatoren verwendet, um die jeweiligen internen Zeiten zu verwalten;
es sich bei der weiteren Einheit um einen Zeitserver des ersten geclusterten Teilnetzwerks handelt;
das Erkennen, dass die Zeit des Zeitservers des ersten geclusterten Teilnetzwerks über den Schwellenwert hinaus abgewichen ist, das Vergleichen der Zeit des Zeitservers des ersten geclusterten Teilnetzwerks mit einer mittleren internen Zeit aller Datenserver aus der Mehrzahl von Datenservern enthält, wobei das Verfahren ferner aufweist:
Vergleichen einer internen Zeit eines Zeitservers eines zweiten der zwei geclusterten Teilnetzwerke mit der mittleren internen Zeit aller Datenserver aus der Mehrzahl von Datenservern;
Erkennen, dass der Zeitserver des zweiten geclusterten Teilnetzwerks in einer im Wesentlichen ähnlichen Weise wie der Zeitserver des ersten geclusterten Teilnetzwerks abgewichen ist; und
als Folge des Erkennens, dass die Zeitserver in einer im Wesentlichen ähnlichen Weise abweichen, Erkennen, dass eine Taktquelle der Zeitserver sowohl an dem ersten wie auch dem zweiten geclusterten Teilnetzwerk beeinträchtigt ist.

11. Computerrealisiertes Verfahren nach Anspruch 1, wobei:
es sich bei dem Datenserver um einen aus einer Mehrzahl von Datenservern handelt, die jeweils eine Mehrzahl von Hochleistungsoszillatoren zum Verwalten der jeweiligen internen Zeiten verwenden;
das Erkennen, dass die Zeit der weiteren Einheit über den Schwellenwert hinaus abgewichen ist, das Vergleichen der Zeit der weiteren Einheit mit einer mittleren internen Zeit aller Datenserver aus der Mehrzahl von Datenservern enthält;
die weitere Einheit einen weiteren Datenserver aus der Mehrzahl von Datenservern enthält; und
die Abhilfemaßnahme die Außerbetriebnahme eines Hochleistungsoszillators des weiteren Datenservers in Reaktion auf das Identifizieren enthält, dass der Hochleistungsoszillator fehlerhaft ist.

12. Computerrealisiertes Verfahren nach Anspruch 1, wobei:
die Mehrzahl von Hochleistungsoszillatoren mindestens vier Oszillatoren enthält, die jeweils für eine Genauigkeit von mindestens ±2 ppm spezifiziert sind; und
der Datenserver zum Verwenden von Software in Verbindung mit der Mehrzahl von Hochleistungsoszillatoren konfiguriert ist, um die interne Zeit so zu verwalten, dass sie an einem Tag nicht mehr als zwei Millisekunden abweicht.

13. Datenserver (120A) in einem Netzwerk aus einer Mehrzahl von Einheiten, wobei der Datenserver aufweist:
eine Mehrzahl von Hochleistungsoszillatoren (122);
einen Prozessor; und
einen Arbeitsspeicher im Datenaustausch mit dem Prozessor, wobei der Arbeitsspeicher Anweisungen (232) enthält, die, wenn sie durch den Prozessor ausgeführt werden, den Prozessor veranlassen zum:
Vergleichen einer internen Zeit des Datenservers mit den jeweiligen Zeiten aller Einheiten aus der Mehrzahl von Einheiten in dem Netzwerk, wobei der Datenserver die Mehrzahl von Hochleistungsoszillatoren zum Verwalten der internen Zeit des Datenservers in dem Netzwerk verwendet, wobei jeder Hochleistungsoszillator in der Mehrzahl von Hochleistungsoszillatoren die interne Zeit des Datenservers einzeln verfolgt, und wobei es sich bei der internen Zeit des Datenservers um eine mittlere Zeit handelt, die von der Mehrzahl von Hochleistungsoszillatoren erhalten wird;
Erkennen durch Analysieren der verglichenen Zeiten, dass eine von einer weiteren Einheit des Netzwerks verwaltete Zeit über einen Schwellenwert hinaus abgewichen ist; und
Ausführen einer Abhilfemaßnahme in Reaktion auf das Erkennen, dass die von der weiteren Einheit verwaltete Zeit über den Schwellenwert hinaus abgewichen ist.

14. Computerprogramm, das auf einem computerlesbaren Speichermedium gespeichert wird und in den internen Arbeitsspeicher eines Digitalcomputer ladbar ist, wobei das Computerprogramm Software-Codeabschnitte zum Durchführen des Verfahrens nach einem der Ansprüche 1 bis 12 aufweist, wenn das Programm auf einem Computer ausgeführt wird.

## Revendications

1. Procédé mis en œuvre par ordinateur comprenant :
la comparaison d'une heure interne d'un serveur de données sur un réseau avec des heures respectives de chacun de la pluralité de dispositifs sur le réseau, dans lequel le serveur de données comprend une pluralité d'oscillateurs à hautes performances pour maintenir l'heure interne du serveur de données sur le réseau, dans lequel chaque oscillateur à hautes performances parmi la pluralité d'oscillateurs à hautes performances suit individuellement l'heure interne du serveur de données et dans lequel l'heure interne du serveur de données est une heure moyenne obtenue à partir de la pluralité d'oscillateurs à hautes performances ;
la détection (310), par analyse des heures comparées, qu'une heure maintenue par un autre dispositif du réseau a dérivé de plus d'un seuil ; et
l'exécution (316, 320) d'une action d'amélioration en réponse à la détection que l'heure maintenue par un autre dispositif a dérivé de plus du seuil.

2. Procédé mis en œuvre par ordinateur selon la revendication 1, dans lequel l'autre dispositif est un serveur horaire du réseau.

3. Procédé mis en œuvre par ordinateur selon la revendication 2, dans lequel :
le serveur de données est un d'une pluralité de serveurs de données qui utilisent chacun une pluralité d'oscillateurs à hautes performances pour maintenir leurs heures internes respectives ;
la détection que l'heure du serveur horaire a dérivé de plus du seuil comprend la comparaison de l'heure du serveur horaire avec une heure interne moyenne de l'ensemble de la pluralité de serveurs de données ; et
l'action d'amélioration comprend à amener le réseau à utiliser l'heure interne moyenne de l'ensemble de la pluralité de serveurs de données plutôt que l'heure du serveur horaire en réponse à la détection que l'heure du serveur horaire a dérivé de plus que le seuil par rapport à l'heure interne moyenne.

4. Procédé mis en œuvre par ordinateur selon la revendication 3, dans lequel l'action d'amélioration est exécutée de manière autonome.

5. Procédé mis en œuvre par ordinateur selon la revendication 1, dans lequel :
le serveur de données est un d'une pluralité de serveurs de données qui utilisent chacun une pluralité d'oscillateurs à hautes performances pour maintenir leurs heures internes respectives ; et
la détection que l'heure d'un autre dispositif a dérivé de plus d'un seuil comprend à comparer l'heure de l'autre dispositif à l'heure interne moyenne de l'ensemble de la pluralité de serveurs de données, le procédé comprenant en outre :
l'identification qu'un commutateur du réseau est une cause de la dérive de plus du seuil de l'autre dispositif par le suivi d'un signal d'horloge erroné envoyé au commutateur.

6. Procédé mis en œuvre par ordinateur selon la revendication 5, dans lequel l'action d'amélioration comprend :
l'envoi d'une notification à un administrateur ; et
l'invocation de l'algorithme Best-Master-Clock.

7. Procédé mis en œuvre par ordinateur selon la revendication 1, dans lequel le réseau utilise un protocole de temps de précision pour synchroniser les heures internes de la pluralité de dispositifs internes.

8. Procédé mis en œuvre par ordinateur selon la revendication 7, dans lequel l'action d'amélioration comprend l'invocation de l'algorithme Best-Master-Clock.

9. Procédé mis en œuvre par ordinateur selon la revendication 1, dans lequel :
l'autre dispositif est un autre serveur de données du réseau ; et
l'action d'amélioration comprend la mise hors service autonome du serveur de données.

10. Procédé mis en œuvre par ordinateur selon la revendication 1, dans lequel :
le réseau est géographiquement dispersé et comprend deux sous-réseaux en cluster ;
le serveur de données est un d'une pluralité de serveurs de données d'un premier des deux sous-réseaux en cluster où chaque serveur de données de la première pluralité de serveurs de données utilise une pluralité respective d'oscillateurs à hautes performances pour maintenir des heures internes respectives ;
l'autre dispositif est un serveur horaire du premier sous-réseau en cluster ;
la détection que l'heure du serveur horaire du premier sous-réseau en cluster a dérivé de plus du seuil comprend la comparaison de l'heure du serveur horaire du premier sous-réseau en cluster avec l'heure interne moyenne de l'ensemble de la pluralité de serveurs de données, le procédé comprenant en outre :
la comparaison d'une heure interne d'un serveur horaire d'un deuxième des deux sous-réseaux en cluster avec l'heure interne moyenne de l'ensemble de la pluralité de serveurs de données ;
la détection que le serveur horaire du deuxième sous-réseau en cluster a dérivé d'une manière sensiblement similaire à celle du serveur horaire du premier sous-réseau en cluster ; et
la détection qu'une source d'horloge des serveurs horaires au niveau des premier et deuxième sous-réseaux en cluster a été compromise suite à la détection que les serveurs horaires dérivent d'une manière sensiblement similaire.

11. Procédé mis en œuvre par ordinateur selon la revendication 1, dans lequel :
le serveur de données est un d'une pluralité de serveurs de données qui utilisent chacun une pluralité d'oscillateurs à hautes performances pour maintenir leurs heures internes respectives ;
la détection que l'heure d'un autre dispositif a dérivé de plus du seuil comprend à comparer l'heure de l'autre dispositif à une heure interne moyenne de l'ensemble de la pluralité de serveurs de données ;
l'autre dispositif comprend un autre serveur de données de la pluralité de serveurs de données ; et
l'action d'amélioration comprend à mettre hors service un oscillateur à hautes performances de l'autre serveur de données en réponse à la détection d'une erreur de l'oscillateur à hautes performances.

12. Procédé mis en œuvre par ordinateur selon la revendication 1, dans lequel :
la pluralité d'oscillateurs à hautes performances comprend au moins quatre oscillateurs, qui sont chacun spécifiés pour une précision d'au moins ± 2 ppm ; et
le serveur de données est configuré pour utiliser un logiciel conjointement à la pluralité d'oscillateurs à hautes performances afin de maintenir l'heure de dérive interne à un maximum de deux millisecondes par jour.

13. Serveur de données (120A) sur un réseau d'une pluralité de dispositifs, comprenant :
une pluralité d'oscillateurs à hautes performances (122) ;
un processeur ; et
une mémoire en communication avec le processeur, la mémoire contenant des instructions (232) qui, lorsqu'elles sont exécutées par le processeur, amènent le processeur à :
comparer une heure interne du serveur de données aux heures respectives de chacun de la pluralité de dispositifs sur le réseau, dans lequel le serveur de données utilise la pluralité d'oscillateurs à hautes performances pour maintenir l'heure interne du serveur de données sur le réseau, dans lequel chaque oscillateur à hautes performances parmi la pluralité d'oscillateurs à hautes performances suit individuellement l'heure interne du serveur de données, et dans lequel l'heure interne du serveur de données est une heure moyenne obtenue à partir de la pluralité d'oscillateurs à hautes performances ;
détecter, par l'analyse des heures comparées, qu'une heure maintenue par un autre dispositif du réseau a dérivé de plus d'un seuil ; et
exécuter une action d'amélioration en réponse à la détection que l'heure maintenue par l'autre dispositif a dérivé de plus d'un seuil.

14. Programme informatique mémorisé sur un support lisible par ordinateur et chargeable dans la mémoire interne d'un ordinateur numérique, le programme informatique comprenant des parties de code logiciel pour exécuter le procédé selon une quelconque des revendications 1 à 12 lorsque ledit programme est exécuté sur un ordinateur.
